# FASCICULE DE BREVET EUROPEEN

(11) **EP 3 113 970 B1**
(45) Date de publication et mention de la délivrance du brevet: **17.10.2018**
(21) Numéro de dépôt: 15711257.4
(22) Date de dépôt: 27.02.2015
(51) Int. Cl.: B60K 37/06, B60H 1/00, G06F 3/044

(54) **INTERFACE DE COMMANDE D'UN SYSTÈME, À ÉCRAN SENSITIF À CONTRÔLE DU RÉTROÉCLAIRAGE DES PICTOGRAMMES**
SYSTEMSTEUERUNGSSCHNITTSTELLE MIT EINEM BERÜHRUNGSBILDSCHIRM MIT PIKTOGRAMMRÜCKBELEUCHTUNGSSTEUERUNG
SYSTEM CONTROL INTERFACE HAVING A TOUCH SCREEN WITH PICTOGRAM BACKLIGHTING CONTROL

(30) Priorité: 06.03.2014 FR 1451805
(43) Date de publication de la demande: 11.01.2017
(73) Titulaire: PSA Automobiles SA, 78300 Poissy (FR)
(72) Inventeur: LAINE, Vincent, F-78340 Les Clayes Sous Bois (FR); TACCORI DUVERGEY, Céline, F-92120 Montrouge (FR)
(74) Mandataire: Jeannin, Laurent Jean-Pierre
(86) Numéro de dépôt international: PCT/FR2015/050478
(87) Numéro de publication internationale: WO 2015/132512

(56) Documents cités:
- DE-A1- 19 735 977
- DE-A1-102008 011 442
- DE-A1-102008 048 820
- DE-A1-102010 010 806
- DE-A1-102010 013 947
- FR-A1- 2 833 386

## Description

L'invention concerne les interfaces de commande qui équipent certains systèmes, comme par exemple certains véhicules, éventuellement de type automobile, et plus précisément le contrôle de l'affichage de pictogrammes associés à des fonctions offertes par de tels systèmes.

Dans certains systèmes, comme par exemple celui des véhicules, éventuellement automobiles, on utilise des interfaces (ou façades) de commande, éventuellement en complément d'un écran multifonctions, pour permettre aux usagers de sélectionner et contrôler des fonctions qui sont offertes par des équipements ou appareils embarqués, comme par exemple une installation de climatisation, des équipements de servitude thermique, une source de diffusion de sons ou un dispositif d'aide à la navigation.

Telles interfaces de commande sont connues du documents DE 10 2010 010 806 A1 et FR 2 833 386 A1.

Ces interfaces (ou façades) de commande comprennent soit des boutons (ou actionneurs), soit des zones sensitives (ou tactiles), soit encore une combinaison de boutons (ou actionneurs) et de zones sensitives (ou tactiles).

Les interfaces (ou façades) de commande à boutons (ou actionneurs) sont fréquemment critiquées par les usagers car ils estiment que la qualité perçue n'est pas très bonne. En outre, elles sont souvent chargées et difficiles à lire, du fait qu'elles comprennent tous les N boutons associés aux N fonctions qui peuvent être offertes par les différents modèles (ou déclinaisons de modèle) d'un même véhicule, alors même que ces derniers offrent des ensembles différents de fonctions choisies parmi ces N fonctions. On comprendra en effet que lorsqu'un modèle (ou déclinaison de modèle) d'un véhicule offre un ensemble de M fonctions (avec M < N), alors N-M boutons de l'interface de commande ne servent strictement à rien ce qui nuit à la qualité perçue et induit un ressenti négatif de l'usager du fait qu'il a conscience de ne pas disposer des N fonctions possibles.

Les interfaces (ou façades) de commande sensitives sont généralement capacitives. Elles comprennent un film comportant des électrodes capacitives (accumulant une charge électrique) et collé derrière une paroi en plastique sur laquelle l'usager peut plaquer un doigt pour provoquer localement une variation de la charge électrique qui est détectée par un microprocesseur dédié et transformée en un ordre d'activation/désactivation de la fonction associée. Ces interfaces (ou façades) de commande offrent un style plus épuré, une meilleure qualité perçue (du fait de l'aspect « sans découpe » (ou « seamless »), et confèrent un caractère technologique qui plait au plus grand nombre, notamment du fait d'une ressemblance avec certains équipements de communication mobiles ou certaines consoles de jeux. Elles permettent également parfois de définir une façade avant noire (ou « black panel ») sur laquelle soit aucun pictogramme (associé à une fonction) n'apparaît lorsque le véhicule ne fonctionne pas, soit les N pictogrammes (associés respectivement aux N fonctions possibles) apparaissent lorsque le véhicule fonctionne. Lors de la mise en fonctionnement du véhicule le rétroéclairage des N zones sensitives contenant les N pictogrammes induit un bel effet visuel. Cependant lorsqu'un modèle (ou déclinaison de modèle) d'un véhicule offre un ensemble de M fonctions (avec M < N), alors N-M zones sensitives de l'interface de commande sont rétroéclairées alors même qu'elles ne servent strictement à rien, ce qui nuit à la lisibilité et à la qualité perçue et induit un ressenti négatif de l'usager du fait qu'il a conscience de ne pas disposer des N fonctions possibles.

Dans un cas comme dans l'autre, pour tenir compte de la diversité des ensembles de fonctions offerts par les différents modèles (ou déclinaisons de modèle) d'un même véhicule, il est possible de fabriquer une interface de commande dédiée à chaque modèle (ou déclinaison de modèle), mais cela induit une augmentation des coûts de production des véhicules et rend beaucoup plus complexe la gestion des stocks.

L'invention a pour but d'améliorer la situation dans le cas des interfaces (ou façades) de commande sensitives.

Elle propose notamment à cet effet une interface de commande, destinée à équiper un système se déclinant selon au moins deux modèles offrant des ensembles différents de fonctions choisies parmi N fonctions, et comprenant, d'une part, un écran d'affichage de couleur foncée et comportant N zones sensitives associées respectivement à N pictogrammes, eux-mêmes associés respectivement aux N fonctions, et propres chacune à permettre à un usager de commander la fonction associée, et, d'autre part, N moyens d'éclairage propres à éclairer respectivement les N pictogrammes.

Cette interface de commande se caractérise par le fait qu'elle comprend en outre des moyens de contrôle agencés pour ne faire fonctionner que des moyens d'éclairage qui sont associés aux pictogrammes associés soit à toutes les fonctions d'un ensemble offert par le système considéré, soit à des fonctions appartenant à un ensemble offert par le système considéré et concernant des zones prédéfinies du système considéré dans lesquelles sont présents des usagers.

Ainsi, une même interface de commande peut prendre en compte la diversité d'un système et éventuellement le contexte d'utilisation de ce système, selon la configuration de ses moyens de contrôle.

L'interface de commande selon l'invention peut comporter d'autres caractéristiques qui peuvent être prises séparément ou en combinaison, et notamment :
- ses moyens de contrôle peuvent être agencés, en cas d'appui d'un usager sur une zone sensitive associée à un pictogramme non éclairé temporairement par le moyen d'éclairage associé, pour faire fonctionner ce dernier moyen d'éclairage afin que l'usager puisse commander la fonction qui lui est associée, alors même qu'aucun usager n'est présent dans la zone prédéfinie associée à cette fonction ;
- ses moyens de contrôle peuvent être agencés pour faire fonctionner des moyens d'éclairage en fonction d'informations disponibles dans un réseau de communication que comprend le système et auquel ils sont couplés ;
- son écran d'affichage peut comprendre au moins i) une partie avant présentant la couleur foncée et comportant les N pictogrammes sensiblement invisibles en l'absence d'éclairement, ii) un film placé derrière la partie avant et comportant N zones capacitives définissant respectivement les N zones sensitives et propres chacune à présenter une variation de capacité induisant une génération d'un signal de commande en présence d'un doigt d'un usager devant la partie avant au niveau de sa zone sensitive, iii) une plaque placée derrière le film et comportant N ouvertures associées respectivement aux N pictogrammes et définies dans les axes respectifs de ces derniers, et iv) une carte électronique comportant les N moyens d'éclairage et des circuits imprimés définissant les moyens de contrôle, des pistes de liaison entre ces derniers et les N moyens d'éclairage, des pistes d'alimentation pour les moyens de contrôle, les N moyens d'éclairage et les N zones capacitives, et des moyens de détection propres à recevoir les signaux de commande générés par les N zones capacitives ;
- les N pictogrammes peuvent être associés à des fonctions qui sont offertes par des équipements choisis parmi une installation de climatisation, au moins un équipement de servitude thermique, au moins une source de diffusion de sons, et un dispositif d'aide à la navigation.

L'invention propose également un système, se déclinant selon au moins deux modèles offrant des ensembles différents de fonctions choisies parmi N fonctions, et comprenant au moins une interface de commande du type de celle présentée ci-avant.

Par exemple, un tel système peut être agencé sous la forme d'un véhicule, éventuellement de type automobile.

D'autres caractéristiques et avantages de l'invention apparaîtront à l'examen de la description détaillée ci-après, et des dessins annexés, sur lesquels :
- la figure 1 illustre schématiquement, dans une vue en perspective, les principaux constituants d'un exemple de réalisation d'une interface de commande selon l'invention avant qu'ils ne soient assemblés les uns aux autres,
- la figure 2 illustre schématiquement, dans une vue en coupe, la partie avant de l'écran sensitif de l'interface de commande de la figure 1,
- la figure 3 illustre schématiquement, dans une vue de face, la face avant de la partie avant de l'écran sensitif de l'interface de commande de la figure 1, lorsque cette dernière ne fonctionne pas,
- la figure 4 illustre schématiquement, dans une vue de face, la face avant de la figure 3 avec tous ses N pictogrammes rétroéclairés,
- la figure 5 illustre schématiquement, dans une vue de face, la face avant de la figure 3 avec N-2 pictogrammes rétroéclairés du fait de l'absence du passager avant,
- la figure 6 illustre schématiquement, dans une vue de face, la face avant de la figure 3 avec N-1 pictogrammes rétroéclairés du fait de l'absence de passagers arrière,
- la figure 7 illustre schématiquement, dans une vue de face, la face avant de la figure 3 avec N-6 pictogrammes rétroéclairés du fait de la sélection du mode de fonctionnement automatique de l'installation de climatisation,
- la figure 8 illustre schématiquement, dans une vue de face, la face avant de la figure 3 avec N-7 pictogrammes rétroéclairés du fait de la sélection du mode de fonctionnement en climatisation maximale de l'installation de climatisation,
- la figure 9 illustre schématiquement, dans une vue de face, la face avant de la figure 3 avec N-4 pictogrammes rétroéclairés du fait que le véhicule n'offre pas de chauffage des sièges avant, de chauffage de la lunette arrière et de contrôle de la climatisation dans la partie arrière de l'habitacle, et
- la figure 10 illustre schématiquement, dans une vue de face, la face avant de la figure 3 avec N-3 pictogrammes rétroéclairés du fait que le véhicule n'offre pas de chauffage des sièges avant et de chauffage de la lunette arrière.

L'invention a notamment pour but de proposer une interface de commande IC de type sensitif et destinée à équiper un système pouvant se décliner selon au moins deux modèles (ou déclinaisons de modèle) offrant des ensembles différents de fonctions choisies parmi N fonctions.

Dans ce qui suit, on considère, à titre d'exemple non limitatif, que le système est un véhicule de type automobile, comme par exemple une voiture. Mais l'invention n'est pas limitée à ce type de système. Elle concerne en effet tout type de système comprenant des équipements ou appareils embarqués offrant des fonctions pouvant être sélectionnées et contrôlées par leurs usagers. Par conséquent, elle concerne notamment tous les véhicules (terrestres, fluviaux (ou maritimes) ou aériens), les installations, éventuellement industrielles, et les appareils ou équipements électroniques.

Par ailleurs, on considère dans ce qui suit, à titre d'exemple non limitatif, que l'interface (ou façade) de commande IC est destinée à permettre à un usager de sélectionner et contrôler un ensemble de fonctions offertes par une installation de climatisation et par des équipements de servitude thermique. Mais l'invention n'est pas limitée à cette application. En effet, l'interface (ou façade) de commande est destinée à permettre à un usager de sélectionner et contrôler un ensemble de fonctions offertes par au moins un équipement ou appareil embarqué dans son système. Par conséquent, elle pourra également et notamment être associée à au moins une source de diffusion de sons (comme par exemple un autoradio) ou un dispositif d'aide à la navigation ou encore un ordinateur de bord.

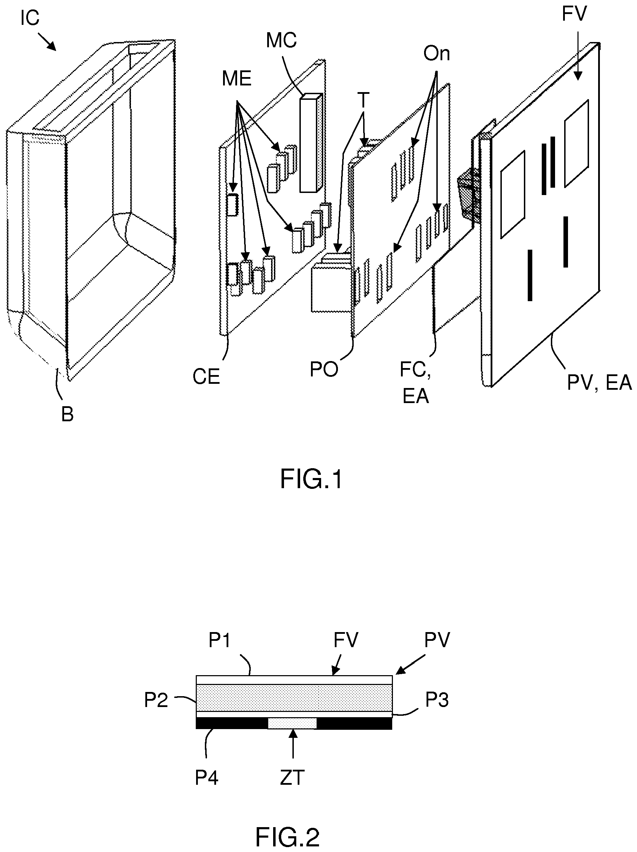

On a schématiquement représenté sur la figure 1 les principaux constituants d'un exemple de réalisation d'une interface de commande IC selon l'invention, avant qu'ils ne soient assemblés les uns aux autres.

Comme illustré non limitativement sur la figure 1, une interface de commande IC selon l'invention comprend au moins un écran d'affichage EA, N moyens d'éclairage ME, et des moyens de contrôle MC.

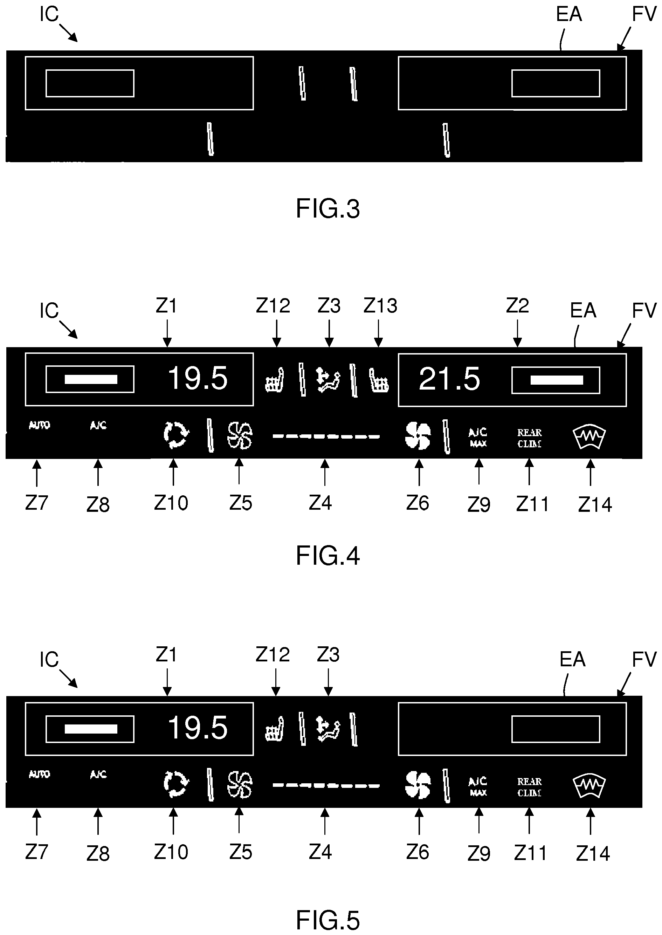

Comme cela apparaît mieux sur les figures 3 à 10, l'écran d'affichage EA présente une couleur foncée, qu'il soit hors fonctionnement (figure 1) ou en fonctionnement (figures 4 à 10). Il comprend une façade avant FV qui semble noire (« black panel »). Par ailleurs, cet écran d'affichage EA comporte N zones sensitives Zn (n = 1 à N) associées respectivement à N pictogrammes, qui sont eux-mêmes associés respectivement à N fonctions qui peuvent être offertes par les différents modèles (ou déclinaisons de modèle) du système considéré (ici un véhicule). Ces N zones sensitives Zn sont propres chacune à permettre à un usager de commander la fonction associée (lorsqu'elle est offerte par le système).

Dans l'exemple de réalisation non limitatif illustré sur les figures 3 à 10, l'interface de commande IC peut être utilisée pour permettre la sélection et le contrôle de différents ensembles de fonctions choisies parmi quatorze fonctions d'une installation de climatisation et d'équipements de servitude thermique. N est donc ici égal à 14. Mais l'invention n'est pas limitée à ce nombre (14). En effet, elle s'applique dès lors que N est supérieur ou égal à deux.

Ici, la première zone Z1 est associée à la température de consigne dans la zone du conducteur, la deuxième zone Z2 est associée à la température de consigne dans la zone du passager avant, la troisième zone Z3 est associée à la distribution d'air dans trois sous-parties de la zone avant du véhicule, la quatrième zone Z4 est associée au débit d'air sélectionné, la cinquième zone Z5 est associée à un débit d'air minimal, la sixième zone Z6 est associée à un débit d'air maximal, la septième zone Z7 est associée au mode de fonctionnement automatique, la huitième zone Z8 est associée au mode de fonctionnement climatisé, la neuvième zone Z9 est associée au mode de fonctionnement climatisé maximal, la dixième zone Z10 est associée au type d'air utilisé (extérieur ou recirculé), la onzième zone Z11 est associée à la climatisation dans la zone arrière du véhicule, la douzième zone Z12 est associée au chauffage du siège conducteur, la treizième zone Z13 est associée au chauffage du siège passager avant, et la quatorzième zone Z14 est associée au chauffage de la lunette arrière du véhicule.

Par exemple, et comme illustré non limitativement sur la figure 1, l'écran d'affichage EA comprend au moins une partie avant PV et un film FC.

La partie avant PV présente la couleur foncée et comporte les N pictogrammes (qui sont sensiblement invisibles en l'absence d'éclairement). Comme illustré non limitativement sur la figure 2, cette partie avant PV peut comprendre :
- une première paroi (ou film) P1 réalisé(e) dans un matériau anti-rayures transparent, et destiné(e) à être contacté(e) par un doigt d'usager,
- une deuxième paroi P2 placée derrière la première paroi P1, fumée, destinée à rendre invisible les pictogrammes lorsqu'ils ne sont pas rétroéclairés, et par exemple réalisée en polycarbonate,
- une troisième paroi P3 noire, placée derrière la deuxième paroi P2, comprenant des zones transparentes ZT dans lesquelles sont définis les N pictogrammes (par exemple par grattage laser), et par exemple réalisée en polycarbonate

Le film FC est placé derrière la partie avant PV et comporte N zones capacitives définissant respectivement les N zones sensitives Zn. Chaque zone capacitive est propre à présenter une variation de capacité (ou de charge électrique) qui induit une génération d'un signal de commande lorsqu'un doigt d'un usager est présent devant (et plus précisément contre) la partie avant PV au niveau de la zone sensitive à laquelle il appartient.

Les N moyens d'éclairage ME sont propres à éclairer respectivement les N pictogrammes (associés respectivement aux N fonctions dans les N zones sensitives Zn).

Par exemple, et comme illustré non limitativement sur la figure 1, ces N moyens d'éclairage ME peuvent être installés sur une carte électronique CE comportant également des circuits imprimés définissant les moyens de contrôle MC, des pistes de liaison entre ces derniers (MC) et les N moyens d'éclairage ME, des pistes d'alimentation pour les moyens de contrôle MC, les N moyens d'éclairage ME et les N zones capacitives du film FC, et des moyens de détection propres à recevoir les signaux de commande générés par les N zones capacitives du film FC.

A titre d'exemple, chaque moyen d'éclairage ME peut comporter au moins une diode électroluminescente (ou LED) dont le fonctionnement est contrôlable par les moyens de contrôle MC.

Comme illustré non limitativement sur la figure 1, l'interface de commande IC peut également comprendre une plaque PO placée derrière le film FC et devant la carte électronique CE, et comportant N ouvertures On associées respectivement aux N pictogrammes et définies dans les axes respectifs de ces derniers. Par exemple, chaque ouverture On est associée à un petit tube T (ici de section rectangulaire) destiné à canaliser jusqu'à elle (On) les photons qui sont produits par le moyen d'éclairage ME associé. Ainsi, la plaque PO constitue une espèce de boîte de lumière.

On notera, comme illustré non limitativement sur la figure 1, que l'interface de commande IC peut également comprendre un boîtier B destiné à loger et protéger au moins la plaque PO et la carte électronique CE (ainsi qu'éventuellement l'écran d'affichage EA, à l'exception, au moins, de sa façade avant FV).

Les moyens de contrôle MC sont agencés pour ne faire fonctionner que des moyens d'éclairage ME qui sont associés aux pictogrammes associés soit à toutes les fonctions d'un ensemble offert par le système considéré, soit à des fonctions appartenant à un ensemble offert par le système considéré et concernant des zones prédéfinies du système considéré dans lesquelles sont présents des usagers.

Autrement dit, les moyens de contrôle MC sont agencés pour ne pas faire fonctionner les moyens d'éclairage ME qui sont associés aux pictogrammes associés lorsque : (i) la fonction associée au pictogramme n'est pas offerte par le système considéré, ou lorsque (ii) la fonction associée au pictogramme concerne une zone prédéfinie dudit système considéré dans laquelle sont des usagers sont absents.

Ainsi, une même interface de commande IC peut très avantageusement être utilisée dans tous les modèles (ou déclinaisons de modèle) d'un même système (ici un véhicule), en ne proposant un rétroéclairage que des pictogrammes qui sont effectivement et respectivement associés aux fonctions offertes par le modèle (ou déclinaison de modèle) considéré(e) et qui concernent éventuellement des zones prédéfinies de ce modèle (ou déclinaison de modèle) considéré(e) dans lesquelles sont présents des usagers. En d'autres termes, une interface de commande IC, selon l'invention, prend en compte la diversité d'un système et éventuellement le contexte d'utilisation de ce système (ici la présence des passagers dans des zones de l'habitacle), selon la configuration de ses moyens de contrôle MC.

On notera que les moyens de contrôle MC peuvent faire partie d'un microcontrôleur défini sur la carte électronique CE et alimenté, par exemple, par un calculateur ou superviseur du véhicule, que l'homme de l'art appelle parfois un « boîtier de servitude intelligent » (ou BSI)).

Lorsque les moyens de contrôle MC prennent en compte le contexte d'utilisation, ils peuvent être agencés, en cas d'appui d'un usager sur une zone sensitive Zn associée à un pictogramme qui n'est pas éclairé temporairement par le moyen d'éclairage ME associé (mais qui est associé à une fonction offerte par le système), pour faire fonctionner ce dernier moyen d'éclairage ME afin que l'usager puisse commander la fonction qui lui est associée, alors même qu'aucun usager n'est présent dans la zone prédéfinie qui est associée à cette fonction.

Par ailleurs, lorsque les moyens de contrôle MC prennent en compte le contexte d'utilisation, il est préférable que lors de la mise en fonctionnement du véhicule et donc de l'interface de commande IC, ils contrôlent le rétroéclairage de tous les pictogrammes associés aux fonctions de l'ensemble qui est offert par ce véhicule, même si le contexte d'utilisation en cours ne le justifie pas, afin de rappeler à l'usager l'existence de toutes ces fonctions. Par exemple, ce n'est qu'après une trentaine de secondes que les moyens de contrôle MC vont déclencher le rétroéclairage des seuls pictogrammes concernant les zones prédéfinies du système considéré dans lesquelles sont présents des usagers.

On notera que de préférence le rétroéclairage contextuel n'est possible que pour des pictogrammes qui ne sont pas associés à des fonctions réglementaires (comme par exemple le dégivrage avant/arrière), du fait que les pictogrammes de ces fonctions réglementaires doivent être visibles en permanence.

On notera également que lorsque le système (ici un véhicule) comprend au moins un réseau de communication (éventuellement de type multiplexé), les moyens de contrôle MC peuvent être agencés pour faire fonctionner des moyens d'éclairage ME en fonction d'informations qui sont disponibles dans (ou accessible sur) ce réseau de communication. Par exemple, le système peut comporter un calculateur ou superviseur qui est notamment chargé d'informer l'interface de commande IC des fonctions qui sont effectivement offertes ainsi que de la présence ou de l'absence d'un passager dans une zone (siège conducteur, siège de passager avant, ou siège de passager arrière). Ces informations de présence sont généralement fournies par un détecteur de présence intégré dans un siège ou par une boucle de ceinture de sécurité associée à ce siège. Par exemple, ce calculateur ou superviseur peut être le boîtier de servitude intelligent (ou BSI). Il est rappelé que ce dernier est un équipement électronique communicant qui est notamment chargé d'assurer l'interconnexion entre plusieurs bus de réseaux de communication embarqués dans le véhicule, des fonctionnalités de diagnostic, le contrôle du fonctionnement de la batterie et du démarreur (ou alterno-démarreur), et l'alimentation en énergie électrique des équipements électriques.

Comme évoqué précédemment, on a schématiquement illustré sur les figures 4 à 10 sept exemples différents d'affichage de pictogrammes sur la façade avant FV d'une interface de commande IC, selon l'invention, en fonctionnement. Les exemples 4 à 8 correspondent à cinq contextes différents pouvant survenir dans un modèle de véhicule équipé d'une installation de climatisation offrant quatorze fonctions contrôlables par un usager (soit N = 14). Les exemples 9 et 10 correspondent à deux modèles de véhicule offrant des ensembles différents de fonction, mais ne prenant pas en compte le contexte d'utilisation.

Dans le premier exemple illustré sur la figure 4, les N pictogrammes sont tous rétroéclairés sur la face avant FV de l'écran d'affichage EA, du fait que les moyens de contrôle MC ont été informés de la présence de passagers sur le siège conducteur, sur le siège du passager avant et sur un siège de passager arrière.

Dans le deuxième exemple illustré sur la figure 5, N-2 pictogrammes sont rétroéclairés sur la face avant FV de l'écran d'affichage EA, du fait que les moyens de contrôle MC ont été informés de l'absence de passager avant sur le siège du passager avant. Ici les deux pictogrammes manquants sont ceux qui sont respectivement associés à la deuxième zone Z2 (associée à la température de consigne dans la zone du passager avant) et à la treizième zone Z13 (associée au chauffage du siège passager avant).

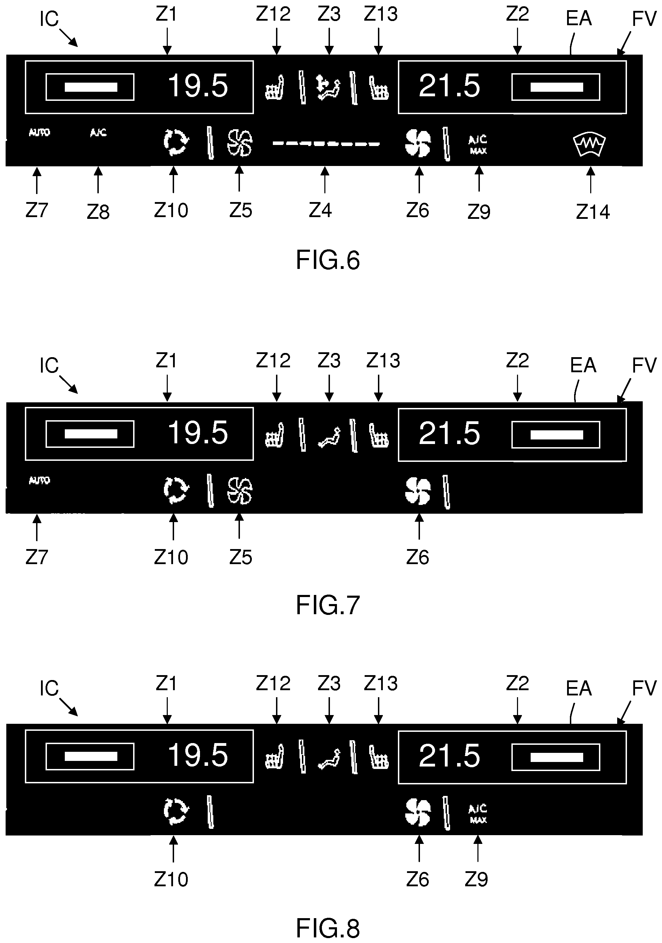

Dans le troisième exemple illustré sur la figure 6, N-1 pictogrammes sont rétroéclairés sur la face avant FV de l'écran d'affichage EA, du fait que les moyens de contrôle MC ont été informés de l'absence de passagers arrière sur les sièges arrière. Ici le pictogramme manquant est celui qui est associé à la onzième zone Z11 (associée à la climatisation dans la zone arrière du véhicule).

Dans le quatrième exemple illustré sur la figure 7, N-6 pictogrammes sont rétroéclairés sur la face avant FV de l'écran d'affichage EA, du fait qu'un usager a sélectionné le mode de fonctionnement automatique de l'installation de climatisation (« AUTO »). Ici les pictogrammes manquants sont respectivement ceux qui sont associés à la troisième zone Z3 (associée à la distribution d'air dans trois sous-parties de la zone avant du véhicule), à la quatrième zone Z4 (associée au débit d'air sélectionné), à la huitième zone Z8 (associée au mode de fonctionnement climatisé), à la neuvième zone Z9 (associée au mode de fonctionnement climatisé maximal), à la onzième zone Z11 (associée à la climatisation dans la zone arrière du véhicule), et à la quatorzième zone Z14 (associée au chauffage de la lunette arrière du véhicule).

Dans le cinquième exemple illustré sur la figure 8, N-7 pictogrammes sont rétroéclairés sur la face avant FV de l'écran d'affichage EA, du fait qu'un usager a sélectionné le mode de fonctionnement en climatisation maximale de l'installation de climatisation (« A/C Max »). Ici les pictogrammes manquants sont respectivement ceux qui sont associés à la troisième zone Z3 (associée à la distribution d'air dans trois sous-parties de la zone avant du véhicule), à la quatrième zone Z4 (associée au débit d'air sélectionné), à la cinquième zone Z5 (associée à un débit d'air minimal), à la septième zone Z7 (associée au mode de fonctionnement automatique), à la huitième zone Z8 (associée au mode de fonctionnement climatisé), à la onzième zone Z11 (associée à la climatisation dans la zone arrière du véhicule), et à la quatorzième zone Z14 (associée au chauffage de la lunette arrière du véhicule).

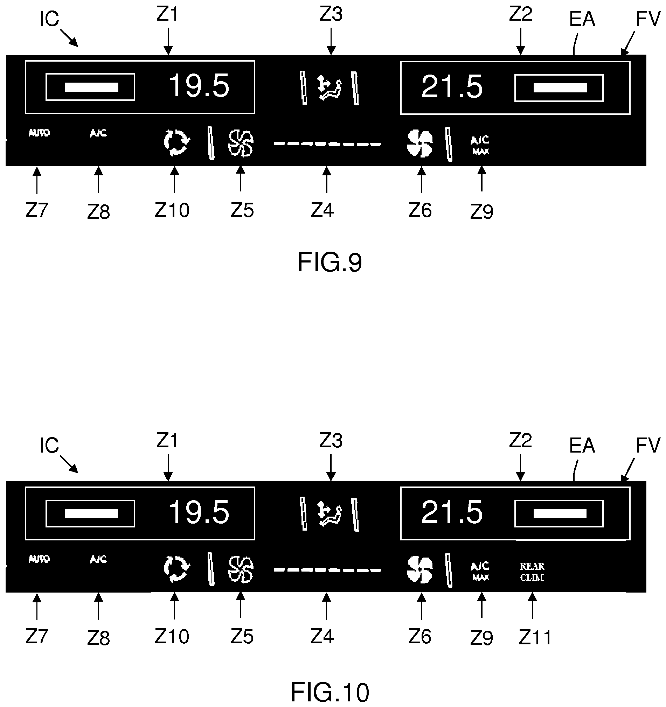

Dans le sixième exemple illustré sur la figure 9, N-4 pictogrammes sont rétroéclairés sur la face avant FV de l'écran d'affichage EA, du fait que les moyens de contrôle MC ont été informés de l'absence de chauffage des sièges avant, de l'absence de chauffage de la lunette arrière et de l'absence de contrôle de la climatisation dans la partie arrière de l'habitacle. Ici les pictogrammes manquants de façon permanente sont respectivement ceux qui sont associés à la onzième zone Z11 (associée à la climatisation dans la zone arrière du véhicule), à la douzième zone Z12 (associée au chauffage du siège conducteur), à la treizième zone Z13 (associée au chauffage du siège passager avant), et à la quatorzième zone Z14 (associée au chauffage de la lunette arrière du véhicule).

Dans le septième exemple illustré sur la figure 10, N-3 pictogrammes sont rétroéclairés sur la face avant FV de l'écran d'affichage EA, du fait que les moyens de contrôle MC ont été informés de l'absence de chauffage des sièges avant et de l'absence de chauffage de la lunette arrière. Ici les pictogrammes manquants de façon permanente sont respectivement ceux qui sont associés à la douzième zone Z12 (associée au chauffage du siège conducteur), à la treizième zone Z13 (associée au chauffage du siège passager avant), et à la quatorzième zone Z14 (associée au chauffage de la lunette arrière du véhicule).

L'invention offre plusieurs avantages, parmi lesquels :
- une réduction du nombre de pictogrammes rétroéclairés, en particulier lorsque le contexte d'utilisation est pris en compte. Cela permet de rendre plus lisibles les façades avant en ne proposant que des commandes nécessaires à l'usager, et de mieux faire comprendre à l'usager ce à quoi servent certaines commandes (comme par exemple la fonction de mode de fonctionnement automatique (ou « AUTO »)) puisqu'il est visuellement informé de ce qu'il peut contrôler et de ce qui est contrôlé par le système,
- une réduction de la diversité des interfaces de commande,
- une amélioration de la qualité perçue du fait de la suppression des découpes entre les commandes.

## Revendications

1. Interface de commande (IC) pour un système se déclinant selon au moins deux modèles d'un véhicule offrant des ensembles différents de fonctions choisies parmi N fonctions, ladite interface de commande (IC) comprenant i) un écran d'affichage (EA) et comportant N zones sensitives (Zn) associées respectivement à N pictogrammes, eux-mêmes associés respectivement auxdites N fonctions, et propres chacune à permettre à un usager de commander la fonction associée, et ii) N moyens d'éclairage (ME) propres à éclairer respectivement lesdits N pictogrammes, **caractérisée en ce qu'**elle comprend en outre des moyens de contrôle (MC) agencés pour ne faire fonctionner que des moyens d'éclairage (ME) qui sont associés aux pictogrammes associés soit à toutes les fonctions d'un ensemble offert par le système considéré, soit à des fonctions appartenant à un ensemble offert par le système considéré et concernant des zones prédéfinies dudit système considéré dans lesquelles sont présents des usagers.

2. Interface de commande selon la revendication 1, **caractérisée en ce que** lesdits moyens de contrôle (MC) sont agencés, en cas d'appui d'un usager sur une zone sensitive (Zn) associée à un pictogramme non éclairé temporairement par le moyen d'éclairage (ME) associé, pour faire fonctionner ce dernier moyen d'éclairage (ME) afin que ledit usager puisse commander la fonction qui lui est associée, alors même qu'aucun usager n'est présent dans la zone prédéfinie associée à cette fonction.

3. Interface de commande selon l'une des revendications 1 et 2, **caractérisée en ce que** lesdits moyens de contrôle (MC) sont agencés pour faire fonctionner des moyens d'éclairage (ME) en fonction d'informations disponibles dans un réseau de communication que comprend ledit système et auquel ils sont couplés.

4. Interface de commande selon l'une des revendications 1 à 3, **caractérisée en ce que** ledit écran d'affichage (EA) comprend au moins i) une partie avant (PV) présentant ladite couleur foncée et comportant lesdits N pictogrammes sensiblement invisibles en l'absence d'éclairement, ii) un film (FC) placé derrière ladite partie avant (PV) et comportant N zones capacitives définissant respectivement lesdites N zones sensitives et propres chacune à présenter une variation de capacité induisant une génération d'un signal de commande en présence d'un doigt d'un usager devant ladite partie avant (PV) au niveau de sa zone sensitive, iii) une plaque (PO) placée derrière ledit film (FC) et comportant N ouvertures (On) associées respectivement auxdits N pictogrammes et définies dans les axes respectifs de ces derniers, et iv) une carte électronique (CE) comportant lesdits N moyens d'éclairage (ME) et des circuits imprimés définissant lesdits moyens de contrôle (MC), des pistes de liaison entre ces derniers (MC) et lesdits N moyens d'éclairage (ME), des pistes d'alimentation pour lesdits moyens de contrôle (MC), lesdits N moyens d'éclairage (ME) et lesdites N zones capacitives, et des moyens de détection propres à recevoir lesdits signaux de commande générés par lesdites N zones capacitives.

5. Interface de commande selon l'une des revendications 1 à 4, **caractérisée en ce que** lesdits N pictogrammes sont associés à des fonctions offertes par des équipements choisis dans un groupe comprenant une installation de climatisation, au moins un équipement de servitude thermique, au moins une source de diffusion de sons, et un dispositif d'aide à la navigation.

6. Système se déclinant selon au moins deux modèles offrant des ensembles différents de fonctions choisies parmi N fonctions, **caractérisé en ce qu'**il comprend au moins une interface de commande (IC) selon l'une des revendications.

7. Système selon la revendication 6, **caractérisé en ce qu'**il est agencé sous la forme d'un véhicule.

8. Système selon la revendication 7, **caractérisé en ce que** ledit véhicule est de type automobile.

## Patentansprüche

1. Steuerungsschnittstelle (IC) für ein System, das gemäß mindestens zwei Modellen eines Fahrzeugs existiert, die Einheiten unterschiedlicher Funktionen bieten, die aus N Funktionen ausgewählt sind, wobei die Steuerungsschnittstelle (IC) i) einen Anzeigebildschirm (EA) umfasst und N empfindliche Zonen (Zn) umfasst, die jeweils mit N Piktogrammen assoziiert sind, die selbst jeweils mit den N Funktionen assoziiert sind, und jeweils geeignet sind, um es einem Benutzer zu erlauben, die assoziierte Funktion zu steuern, und ii) N Beleuchtungsmittel (ME), die geeignet sind, um jeweils die N Piktogramme zu beleuchten, **dadurch gekennzeichnet, dass** sie außerdem Kontrollmittel (MC) umfasst, um nur Beleuchtungsmittel (ME) funktionieren zu lassen, die mit den Piktogrammen assoziiert sind, die entweder mit allen Funktionen einer Einheit assoziiert sind, die von dem betreffenden System geboten werden, oder mit Funktionen, die zu einer Einheit gehören, die von dem betreffenden System geboten werden, und die die vordefinierten Zonen des betreffenden Systems, in dem Benutzer gegenwärtig sind, betreffen.

2. Steuerungsschnittstelle nach Anspruch 1, **dadurch gekennzeichnet, dass** die Kontrollmittel (MC) eingerichtet sind, um bei einem Druck eines Benutzers auf eine empfindliche Zone (Zn), die mit einem Piktogramm assoziiert ist, die vorübergehend nicht von dem assoziierten Beleuchtungsmittel (ME) beleuchtet wird, dieses Letztere Beleuchtungsmittel (ME) funktionieren zu lassen, damit der Benutzer die Funktion, die mit ihm assoziiert ist, steuern kann, während kein Benutzer in der vordefinierten Zone, die mit dieser Funktion assoziiert ist, gegenwärtig ist.

3. Steuerungsschnittstelle nach einem der Ansprüche 1 und 2, **dadurch gekennzeichnet, dass** die Kontrollmittel (MC) eingerichtet sind, um Beleuchtungsmittel (ME) in Abhängigkeit von Informationen funktionieren zu lassen, die in einem Kommunikationsnetzwerk, das in dem System, mit dem sie gekoppelt sind, verfügbar sind.

4. Steuerungsschnittstelle nach einem der Ansprüche 1 bis 3, **dadurch gekennzeichnet, dass** der Anzeigebildschirm (EA) mindestens i) einen Vorderteil (PV) umfasst, der die dunkle Farbe aufweist und die N Piktogramme umfasst, die im Wesentlichen bei Fehlen von Beleuchtung unsichtbar sind, ii) eine Folie (FC), die hinter dem Vorderteil (PV) platziert ist und N kapazitive Zonen umfasst, die jeweils die N empfindlichen Zonen definieren und jeweils geeignet sind, eine Kapazitätsvariation aufzuweisen, die ein Erzeugen eines Steuersignals bei Gegenwart eines Fingers eines Benutzers vor dem Vorderteil (PV) im Bereich seiner empfindlichen Zone induziert, iii) eine Platte (PO), die hinter der Folie (FC) platziert ist und N Öffnungen (On) umfasst, die jeweils mit den N Piktogrammen assoziiert und in den jeweiligen Achsen dieser Letzteren definiert sind, und iv) eine Elektronikkarte (CE), die die N Beleuchtungsmittel (ME) und gedruckte Schaltungen, die die Kontrollmittel (MC) definieren, Verbindungsbahnen zwischen diesen Letzteren (MC) und den N Beleuchtungsmitteln (ME), Versorgungsbahnen für die Kontrollmittel (MC), die N Beleuchtungsmittel (ME) und die N kapazitiven Zonen und Erfassungsmittel umfasst, die geeignet sind, um die Steuersignale, die von den N kapazitiven Zonen erzeugt werden, zu empfangen.

5. Steuerschnittstelle nach einem der Ansprüche 1 bis 4, **dadurch gekennzeichnet, dass** die N Piktogramme mit Funktionen assoziiert sind, die von Ausstattungen geboten werden, die aus einer Gruppe ausgewählt sind, die eine Klimaanlage, mindestens eine Wärmesteuerausstattung, mindestens eine Schallverbreitungsquelle und eine Navigationshilfsvorrichtung umfasst.

6. System, das in mindestens zwei Modellen existiert, die unterschiedliche Einheiten von Funktionen bieten, die aus N Funktionen ausgewählt sind, **dadurch gekennzeichnet, dass** es mindestens eine Steuerungsschnittstelle (IC) nach einem der Ansprüche umfasst.

7. System nach Anspruch 6, **dadurch gekennzeichnet, dass** es in der Form eines Fahrzeugs eingerichtet ist.

8. System nach Anspruch 7, **dadurch gekennzeichnet, dass** das Fahrzeug vom Typ Automobil ist.

## Claims

1. A control interface (IC) for a system available in at least two models of a vehicle offering different sets of functions selected from among N functions, said control interface (IC) including i) a display screen (EA) and comprising N touch screen areas (Zn) associated, respectively, with N pictograms, which are in turn respectively associated with said N functions, and each capable of permitting a user to control the associated function, and ii) N lighting means (ME) capable of illuminating, respectively, said N pictograms, **characterized in that** it further includes control means (MC) arranged so as to only cause lighting means (ME) to function which are associated with the pictograms associated either with all the functions of a set offered by the system in question, or with functions belonging to a set offered by the system in question and concerning predefined areas of the said system in question in which users are present.

2. The control interface according to Claim 1, **characterized in that** said control means (MC) are arranged, in the case of pressure by a user on a touch screen area (Zn) associated with a pictogram which is not lit temporarily by the associated lighting means (ME), to cause this latter lighting means (ME) to function, so that said user can control the function which is associated therewith, even though no user is present in the predefined area associated with this function.

3. The control interface according to one of Claims 1 and 2, **characterized in that** said control means (MC) are arranged to cause lighting means (ME) to function as a function of information available in a communication network which said system includes, and to which they are coupled.

4. The control interface according to one of Claims 1 to 3, **characterized in that** said display scree (EA) includes at least i) a front portion (PV) having said deep colour and comprising said N pictograms which are substantially invisible in the absence of lighting, ii) a film (FC) placed behind said front portion (PV) and comprising N capacitive zones defining respectively said N touch screen areas and each capable of presenting a variation in capacitance inducing a generation of a control signal in the presence of a finger of a user in front of said front portion (PV) at the level of its touch screen area, iii) a sheet (PO) placed behind said film (FC) and comprising N openings (On) associated respectively with said N pictograms and defined in the respective axes of these latter, and iv) an electronic board (CE) comprising said N lighting means (ME) and printed circuits defining said control means (MC), connecting tracks between these latter (MC) and said N lighting means (ME), supply tracks for said control means (MC), said N lighting means (ME) and said N capacitive zones, and detection means capable of receiving said control signals generated by said N capacitive zones.

5. The control interface according to one of Claims 1 to 4, **characterized in that** said N pictograms are associated with functions offered by equipment selected from a group including an air-conditioning installation, at least one item of heat control equipment, at least one sound diffusion source, and one navigation aid device.

6. A system available in at least two models offering different sets of functions selected from among N functions, **characterized in that** it includes at least one control interface (IC) according to one of the claims.

7. The system according to Claim 6, **characterized in that** it is arranged in the form of a vehicle.

8. A system according to Claim 7, **characterized in that** said vehicle is of the automobile type.
